# EUROPEAN PATENT SPECIFICATION

(11) **EP 1 445 999 B1**
(45) Date of publication and mention of the grant of the patent: **03.10.2007**
(21) Application number: 03388025.3
(22) Date of filing: 25.04.2003
(51) Int. Cl.: H05K 9/00

(54) **A method of providing a PWB with a shield can and a PWB therefor**
Verfahren zum Versehen einer Leiterplatte mit einem Abschirmdeckel und Leiterplatte dafür
Procédé pour munir un circuit imprimé d'un boîtier de blindage et le circuit imprimé pour ce

(30) Priority: 07.02.2003 EP 03388006
(43) Date of publication of application: 11.08.2004
(73) Proprietor: Sony Ericsson Mobile Communications AB, 221 88 Lund (SE)
(72) Inventor: Fagrenius, Gustav, 224 68 Lund (SE); Bengtsson, Henrik, 224 65 Lund (SE); Sandevi, Tommy, 211 26 Malmö (SE); Hermann, Fredrik, 217 54 Malmö (SE); Andersson, Niklas, 226 44 Lund (SE); Meynert, Hans, 234 43 Lomma (SE)
(74) Representative: Andersen, Poul Hoeg

(56) References cited:
- EP-A- 0 407 072
- EP-A- 0 735 811
- FR-A- 2 775 554
- GB-A- 2 378 042
- US-A1- 2001 002 877
- US-A1- 2002 096 344
- US-B1- 6 192 577
- US-B1- 6 462 436
- PATENT ABSTRACTS OF JAPAN vol. 1998, no. 05, 30 April 1998 (1998-04-30) -& JP 10 022679 A (SAITAMA NIPPON DENKI KK), 23 January 1998 (1998-01-23)

## Description

### Technical field

The invention relates to a method of providing a PWB (printed wired board) with a shield can and a PWB therefor.

### Related prior art

In order to shield electronic components on a PWB (printed wired board) in electronic devices against electro-magnetic radiation, a shielding in the form of an electrically conductive shield can or box is conventionally placed on the PWB covering the electronic components. The highest level of shielding is achieved when a closed metal can with a free rim at downwardly extending side walls is soldered to the PWB along the entire free edge of the metal can. A critical requirement that must be fulfilled in order to achieve good shielding is that the solder joint between the shield can and the PWB is well controlled, preferably without leaving any unsoldered areas. If any areas remain unsoldered the shielding efficiency is determined by the largest gap between the shield can and the PWB. Therefore, if gaps exist between the shield can and the PWB the sizes of these must be well defined.

The preferred method today for mounting electronic components to the PWB is to use the so-called surface mount technology (SMT) with a re-flow soldering method. In this method a solder paste is used which is a substance with cream-like consistency made up of solder, flux and a carrying medium. The mixture of solder and flux is 85%-95% solder and 5%-15% flux, where the solder consists of small particles shaped as balls and needles. There are high quality demands on the solder paste, when used in the electronic industry. The solder paste should e.g. easily wet the components and the pads on the PWB, not flow so much that it connects two nearby pads on the PWB, be sticky to hold the components during assembly and not get stuck in the holes of the screen-printing stencil, when such a stencil is used for applying the solder paste.

The first step in a soldering process is to apply the solder paste to pads on the PWB. This can be done by several methods including:
- Dispense solder paste through the end of a tube.
   This method is very similar to using a syringe. The solder paste is slightly pressurised and is dispensed through the end of a tube. Advantages of this method are for example that it allows little opportunity for solder contamination, since it employs a closed container for the solder paste.
   Other advantages include that the tube can reach into odd shaped places and that it is a relatively inexpensive method. Disadvantages of this method include that it is very difficult to apply the precise amount of solder paste to the PWB and that it is a relatively slow method.
- Dip dull pins into the solder paste.
   When using this method, dull pins are dipped into solder paste and the ends of the pins are then dabbed onto the PWB. The amount of solder paste is directly proportional to the size and shape of the pins. An advantage of this method is that it is fast, since it is possible to lower a whole array of pins onto the board at the same time.
- Screen-printing.
   Screen-printing is a method that yields an excellent result when applying solder paste, since it gives an exact and predetermined thickness of the layer of solder paste. A screen-printing stencil is made by a fine mesh of polyester or metal. The screen-printing stencil is placed slightly above the PWB and a squeegee is drawn over the stencil with a pressure that forces the solder paste through the stencil onto the PWB. The squeegee could be made of metal or rubber. If it is made of rubber, it is possible to put different amounts of solder paste on different places on the PWB. However, it has to be sharpened quite often.
- Stencil-printing.
   This method is very similar to screen-printing. The difference is that the stencil is not elastic and therefore the stencil is placed in contact with the PWB. Stencil-printing is mostly used for fine-pitch devices. This is a method that is perfectly suitable for high-volume production.

The preferred method for applying the solder paste to the PWB is the screen printing method described above. The PWB is screen-printed with solder paste at the desired areas where electronic components and the shield can(s) are to be mounted. The thickness of the solder paste is determined by the thickness of the screen-printing stencil and is the same all over the PWB.

The next step is to place the electronic components on the PWB by a pick-and-place machine. The shield can(s) is (are) normally placed on the PWB after the other components have been placed since shield cans must cover one or more of them. In the last step of the process the PWB is heated in a soldering oven, whereby the applied solder paste melts and all the components and the shield can(s) become soldered to the PWB.

When the PWB, together with the components, travels through the oven to melt the solder paste, the temperature follows a predetermined pattern. The oven is first heated to a temperature where the flux in the solder paste becomes active and the temperature is held for a period of time that is long enough to let the flux clean the base metal. After this, the temperature is raised above the melting temperature of the solder paste. The temperature is usually held at this level for 30 to 60 seconds, long enough to let the solder wet the PWB and the components. The last step is cooling the PWB, which is done at a continuous rate. There is a trade off in the cooling process. If the PWB is cooled quickly, the solder bonds will be strong, but it will introduce stresses in the PWB. Therefore, the cooling process must be controlled for ensuring a relatively strong bond without introducing too high stresses in the PWB.

Since small components, such as resistors and capacitors, need small volumes of solder paste and large components, such as shield cans, need large volumes of solder pate, the thickness of the screen-printing stencil has to be set as a compromise between these two different needs. Electronic components are constantly getting smaller in order to save space on the PWB, and smaller electronic components must have less solder paste in order to get soldered properly. Thinner screen-printing stencils will therefore be used in the future.

However, neither the shield cans nor the PWBs can be manufactured perfectly flat and, furthermore, the non-planarity of especially the PWB may be affected by the heat in the soldering oven. This means that there will always be a gap between the shield can and the PWB, which, however, is not a problem as long as the gap is filled with solder during heating. As described above the thickness of the solder paste initially applied to the PWB is limited and may in the future be decreased even further. This means that the acceptable size of the gap is also limited, if it must be ensured that the gap becomes filled with solder during the heating process. Furthermore, the size of the gap between the shield can and the PWB increases with the size of the shield can, and the size of the shield can must therefore be limited in order to ensure that the gap can be filled with the pre-applied solder paste.

In modern electronic devices that tend to be increasingly smaller it is desirable to combine several small shield cans into one large shield can with internal walls, since this will save space on the PWB. Fewer shield cans also result in faster assembling and a reduction in the manufacturing costs. Larger shield cans will, however, increase the risk for unsoldered gaps between the shield can and the PWB due to a non-planar PWB and/or a non-planar shield can.

An attempt to overcome this problem has been to dispense an extra thick layer of solder paste to the area of the PWB where the shield can is to be positioned. However, this calls for an undesired extra manufacturing step.

Documents US 2001/002877, US 6,462,436, FR 2,755,554 and JP 10 022679 disclose a method where a groove is milled into the PWB and filled with solder. The edge of the shield can is then inserted into the groove.

### Object of the invention

It is an object of the invention to provide a method for providing a PWB with a shield can in which the risk of unacceptable gaps between the mounted shield can and the PWB is eliminated. Another object is to provide a PWB adapted for use in this method.

### Summary of the invention

The object described above is achieved by incorporating the following steps in the method for providing the PWB with a shield can:
- providing an electrically conductive shield can with a rim;
- providing a groove on a surface of the PWB,
   - said groove being wider than a thickness of the shield can at the rim, and
   - said groove having a contour corresponding to a contour of the rim of the shield can;
- applying a solder paste to the PWB to substantially fill said groove with solder paste;
- positioning the shield can on said solder paste with its rim aligned with said groove on said PWB;
- heating the PWB with the shield can and solder paste to solder the shield can to the PWB;
- cooling the PWB with the shield can,
wherein the groove is provided by applying two parallel strips that protrude from the surface of the PWB.

Thereby is obtained that during the solder paste application step, e.g. by screen-printing or stencil-printing, an extra amount of solder paste will automatically be applied to the PWB at the area of the shield can since the groove will be filled with solder paste. Therefore, when the PWB and the shield can are heated in an oven the solder paste in the groove melts and the rim of the shield can will extend into the groove. The depth of the groove decides the tolerances towards co-planarity; i.e. the deeper the groove the larger bending of the PWB can be accepted.

According to the invention, the groove is provided by applying two parallel strips that protrude from the surface of the PWB. These strips serve the same function as a milled or etched groove, i.e. to receive an extra amount of solder paste and the rim of the shield can. The advantage of this method is that the layers of the PWB are not influenced.

The strips may advantageously be applied by plating copper onto the PWB, which is a well-known and well-substantiated method.

The groove need not be provided as a single continuous groove, but may be made as a plurality of discrete grooves, while the rim of the shield can is made with an equal number of protrusions that are complementary with the grooves. Thereby is obtained that less solder paste is required and that, in case the grooves are milled or etched into the surface of the PWB, it is still possible to leave some parts of the upper layers of the PWB uninterrupted.

The invention is also related to a PWB that is especially adapted for use in the method described above, and it is characterised in that the PWB is provided with a groove adapted to receive a rim of the shield can.

Again the groove according to the current invention is provided between two parallel strips that protrude from the surface of the PWB. Such strips may advantageously comprise copper that is plated onto the PWB.

The groove need not be provided as a single continuous groove, but may consist of a plurality of discrete grooves adapted to receive protrusions provided on the rim of the shield can with the advantages described above.

It shall be emphasised that the term "comprise/comprising" when used in this specification is taken to specify the presence of stated features, integers, steps or components, but does not preclude the presence or addition of one or more other features, integers, steps, components or groups thereof.

### Description of the drawings

The invention will be described in detail in the following with reference to the drawings described below. It should be noted that the examples shown in figures 2-8 do not comprise part of the invention.
Figs 1a and 1b illustrate the problems associated with the prior art shield cans;
Fig. 2 shows a first example of a PWB and a shield can therefor;
Fig. 3 shows a cross-section of the PWB and the shield can shown in Fig. 1 with solder paste applied to the PWB;
Fig. 4 shows the same detail as Fig. 3 after heating the PWB/shield can assembly;
Fig. 5 shows partly in cross-section the PWB and shield can of Fig. 1 after assembling;
Fig. 6 shows another example of a shield can provided with recesses with an extra amount of solder paste;
Fig. 7 shows partly in cross-section the PWB and shield can of Fig. 6 after assembling;
Fig. 8 shows yet example example of a PWB and a shield can; and
Fig. 9 shows in cross-section an embodiment of a PWB and a shield can in accordance with the invention.

### Detailed description of an embodiment of the invention

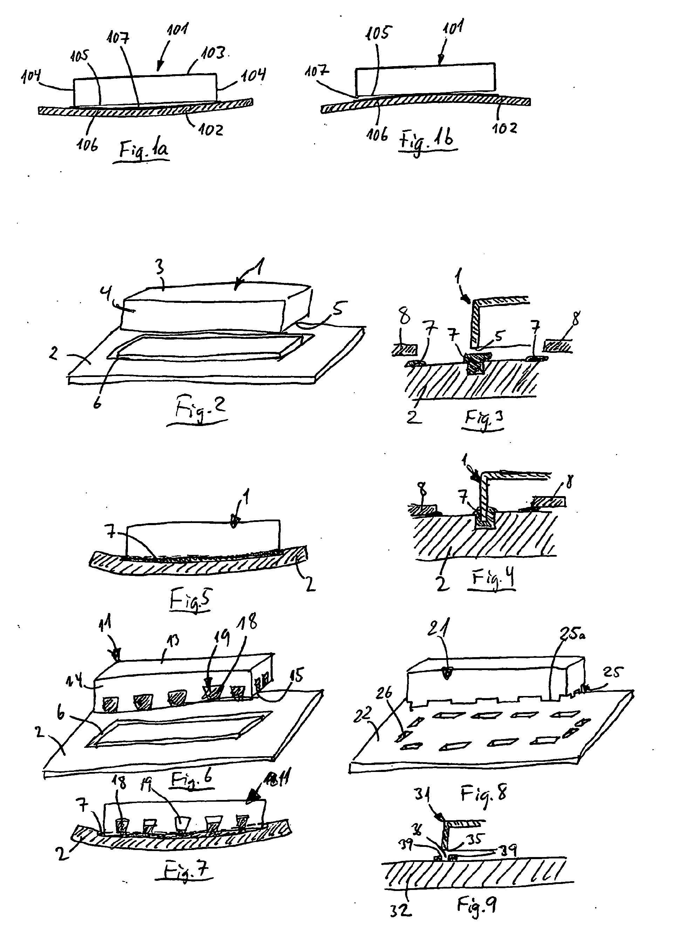

Figs 1 a and 1b show cross-sections taken through a shield can 101 and a PWB 102 and illustrate the problems associated with the prior art method for mounting a shield can 101 on a PWB 102. In the embodiment shown, the shield can 101 is box-shaped and consists of a metal shell forming a flat upper cover part 103 and four downwardly extending side walls 104 with a free rim 105. As described above PWBs 102 are never totally planar due to internal stresses in the PWB 102 occasioned by the manufacturing process. Figs 1 a and 1 b each shows a PWB 102 that bends downwards and upwards, respectively. In order to better illustrate the problems associated with the prior art mounting of a shield can 101 on a PWB 102 the bending of the PWBs 102 as shown in Figs 1 a and 1b is exaggerated. Furthermore, for clarity reasons no other components than the shield can 101 is shown; in practice the electronic components to be shielded are positioned on the PWB 102 within the mounted shield can 101. In Figs 1 a and 1 b the PWB 102 is provided with a pre-applied thin layer of solder paste 106 provided at the area where the rim 105 of the shield can 101 is intended to be connected to the PWB 102 by heating of the pre-applied solder paste 106.

In Fig. 1a the PWB 102 bends downwards, and due to this downwards bending a gap 107 exists between the PWB 102 and the rim 105 of the shield can 101. It is not possible to close the gap 107 with the pre-applied solder paste 106, and if the PWB 102 bends as much as shown in Fig. 1a the gap 107 extends from one side of the shield can 101 to the other. Thereby the shielding efficiency is substantially reduced.

In the situation shown in Fig. 1b the PWB 102 bends upwards and the rim 105 of the shield can 101 is connected to the PWB 102 at a very limited area only. In this instance the gap 107, which is not closed by the pre-applied solder paste 106, between the PWB 102 and the rim 105 of the shield can 101 extends over more than two sides of the shield can 101. Again the shielding efficiency of the shield can 101 is substantially reduced.

In practice, the PWB 102 bends less than shown in Figs 1 a and 1 b and the gap 107 is smaller than shown. However, since the degree of bending of the PWB 102 - and of the shield can 101 as well - is to some degree unpredictable, there is always a risk that a gap 107 of an unpredictable size occurs, thereby reducing the shielding efficiency.

Fig. 2 shows a PWB 2 and a shield can 1 therefor. The shield can 1 is box-shaped and comprises of a metal shell forming a flat upper cover part 3 and four downwardly extending side walls 4 with a free rim 5. The PWB 2 may be of any conventional type and is provided with a groove 6 that is configured to receive the rim 5 of the shield can 1.

Fig. 3 shows a cross-section of the PWB 2 in the area of the groove 6 after solder paste 7 has been applied to the surface of the PWB 2. Due to the depth of the groove 6 there will be an extra amount of solder paste 7 in this area beneath the shield can 1.

The solder paste 7 is typically applied to the PWB 2 in a thickness of 0.1 mm using the screen-printing or the stencil-printing methods described above. If the depth of the groove 6 is at least 0.1 mm the thickness of the solder paste 7 beneath the rim 5 of the shield can 1 is at least doubled in relation to the thickness of the solder paste 7 elsewhere on the surface of the PWB 2 intended for surface mounting of electronic components 8. Thereby it can be ensured that even if the PWB 2 bends slightly after mounting of the shield can 1 as shown in Fig 5 no gaps will be present between the PWB 2 and the rim 5 of the shield can 1.

Fig. 6 shows another example a shield can 11 for use with the PWB 2 provided with a groove 6 configured for receiving the rim 15 of the shield can 11. The shield can 11 is also box-shaped and comprises a metal shell forming a flat upper cover part 13 and four downwardly extending side walls 14 with a free rim 15.

In this example the rim 15 is provided with an extra amount of solder paste 18 located in pockets or recesses 19 provided at the side walls of the shield can 11. The recesses 19 may be manufactured by etching or embossing the side walls 14 and may be filled with solder paste by e.g. screen-printing or dispensing.

The recesses 19 are V-shaped in order to control the "delivery" of solder paste 18 when the shield can 11 is placed on the PWB 2 and heated as described below.

Fig. 7 shows the shield can 11 placed on the PWB 2 that bends downwards. The groove 6 is filled with solder paste 7 as described above with reference to Figs 2-5, and when the shield can 11 with the extra amount of solder paste 18 and the PWB 2 are heated, the extra amount of solder paste 18 melts and flows down and out of the V-shaped recesses 19 to unite with the solder paste 7 provided in the groove 6. In this manner a larger amount of solder paste 7,18 is provided at the interconnection between the PWB 2 and the rim 15 of the shield can 11 than it is the case above with reference to Figs 2-5. It is thereby further ensured that any non-planarity of the PWB 2 does not influence the shielding capacity of the shield can 11.

Fig. 8 shows yet another example of a PWB 22 and a shield can 21 in which the groove in the PWB 22 for receiving the rim of the shield can 21 consists of a plurality of shorter, discrete grooves 26 provided in the surface of the PWB 22. Likewise, the rim 25 of the shield can 21 is provided with protrusions 25a that are configured complementary with the grooves 26. In use solder paste is applied to the PWB 22 by e.g. screen-printing and the grooves 26 are filled with solder paste in a manner similar to that shown in Fig. 3. The protrusions 25a provided at the rim 25 of the shield can 21 are positioned above the grooves 26 and during heating the solder paste melts and the protrusions 25a on the rim 25 are displaced into the grooves 26.

Using this example may result in gaps being provided between the PWB 22 and the shield can 21 when the shield can 21 has been soldered to the PWB 22. Possible gaps will occur in the areas between the protrusions 25a. However, the sizes of these gaps are well-defined since they will never exceed the distances between the protrusions 25a. Generally, the gaps should be kept as small as possible in order to provide sufficient shielding. This can easily be achieved by dimensioning the distance between the protrusions 25a correctly.

The risk of gap appearance may be reduced if recesses for solder paste like the recesses 19 shown in Figs 6 and 7 are provided on the side faces of the shield can 21 between the protrusions 25a. During the heating process this extra amount of solder paste will flow down and form a bridge to the PWB 22.

The groove for receiving the rim of the shield according to the invention is provided by applying two parallel strips 39 of e.g. copper to the surface of the PWB 32 as shown in Fig. 9 which shows a cross-section of a PWB 32 and a shield can 31. This embodiment is particularly relevant when it is undesirable to mill or edge a groove into the surface of the PWB 32. The strips 39 may be applied by plating extra copper to the desired areas such that walls are built on top of the PWB 32 where the shield can 31 is to be placed. The space between the strips 39 has the same function as the milled or edged groove, i.e. it provides room for extra solder paste and increases the tolerances towards co-planarity.

An advantage of this embodiment is that the different layers of the PWB 32 are not affected, which in turn means that it can be applied to any existing PWB 32 without any need of re-designing the PWB 32. It is a well-proven method to selectively plate the PWB 32 with extra copper, and there will be no problems in creating the strips within the tolerance limits.

The invention has been described with reference to a preferred embodiment employing a box-shaped shield can. However, the shield can need not be box-shaped; it may also be dome-shaped or shaped as any other hollow, three-dimensional member provided with a downwardly extending rim. The shield can may also be provided with internal walls that extend from the top of the shield can to the PWB for dividing the shield can into any desired closed volumes. Corresponding grooves should then be made on the PWB.

When choosing the material of the shield can, there is a wide selection of different materials to choose from. Different types of plastic materials and metal alloys with varying shielding characteristics are used on the market. Metal cans are mainly used for non-complicated geometries and are relatively inexpensive. The possibilities to create more complicated geometries increase when using a plastic material, but these types of shield cans are often more expensive to produce. In order to obtain sufficient shielding effectiveness, the plastic material must be conductive and this is achieved by e.g. spraying it with conductive paint.

## Claims

1. A method of providing a PWB (printed wired board) (2;22;32) with a shield can (1;11;21;31) which method comprises the steps of:
- providing an electrically conductive shield can (1;11;21;31) with a rim (5;15;25;35);
- providing a groove (6;26;36) on a surface of the PWB,
- said groove (6;26;36) being wider than a thickness of the shield can at the rim, and
- said groove (6;26;36) having a contour corresponding to a contour of the rim of the shield can (1;11;21;31);
- applying a solder paste (7) to the PWB to substantially fill said groove (6;26;36) with solder paste (7);
- positioning the shield can (1;11;21;31) on said solder paste (7) with its rim (5;15;25;35) aligned with said groove on said PWB;
- heating the PWB with the shield can and solder paste to solder the shield can to the PWB;
- cooling the PWB with the shield can,
**characterised in that** the groove (36) is provided by applying two parallel strips (39) that protrude from the surface of the PWB (32).

2. A method according to claim 1, **characterised in that** the strips (39) are applied by plating copper onto the PWB (32).

3. A method according to claim 1 or 2, **characterised in that** the groove is made as a plurality of discrete grooves (26), and that the rim (25) of the shield can (21) is made with an equal number of protrusions (25a) that are complementary with the grooves (26).

4. A PWB (printed wired board) (2;22;32) for mounting of electronic components (8) and at least one shield can (1;11;21;31) for shielding the electronic components and where the PWB (2;22;32) is provided with a groove (6;26;36) adapted to receive a rim (5;15;25;35) of the shield can **characterised in that** the groove (36) is provided between two parallel strips (39) that protrude from the surface of the PWB (32).

5. A PWB according to claim 4, **characterised in that** the strips (37) comprise copper plated onto the PWB (39).

6. A PWB according to claim 4 or 5, **characterised in that** the groove consists of a plurality of discrete grooves (26) adapted to receive protrusions (25a) provided on the rim (25) of the shield can (21).

## Patentansprüche

1. Verfahren zum Bereitstellen eines PWBs (printed wired board) (2; 22; 32) mit einem Abschirmungsgehäuse (1; 11; 21; 31), wobei das Verfahren die Schritte umfasst:
- Bereitstellen eines elektrisch leitfähigen Abschirmungsgehäuses (1; 11, 21, 31) mit einer Kante (5; 15; 25; 35);
- Bereitstellen einer Nut (6; 26; 36) auf einer Oberfläche des PWBs,
- wobei die Nut (6; 26; 36) breiter als die Dicke des Abschirmungsgehäuses an der Kante ist, und
- wobei die Nut (6; 26; 36) eine Kontur aufweist, die einer Kontur der Kante des Abschirmungsgehäuses (1; 11; 21; 31) entspricht;
- Aufbringen einer Lötpaste (7) auf das PWB, um die Nut (6; 26; 36) im Wesentlichen mit Lötpaste (7) zu füllen;
- Anordnen des Abschirmungsgehäuses (1; 11; 21; 31) auf der Lötpaste (7), wobei seine Kante (5; 15; 25; 35) bezüglich der Nut auf dem PWB ausgerichtet ist;
- Erhitzen des PWBs mit dem Abschirmungsgehäuse und der Lötpaste, um das Abschirmungsgehäuse mit dem PWB zu verlöten;
- Abkühlen des PWBs mit dem Abschirmungsgehäuse;
**dadurch gekennzeichnet, dass** die Nut (36) durch Aufbringen zweier paralleler Streifen (39) bereitgestellt wird, die von der Oberfläche des PWBs (32) hervorstehen.

2. Verfahren nach Anspruch 1, **dadurch gekennzeichnet, dass** die Streifen (39) durch Plattieren von Kupfer auf das PWB (32) aufgebracht werden.

3. Verfahren nach Anspruch 1 oder 2, **dadurch gekennzeichnet, dass** die Nut als eine Vielzahl von einzelnen Nuten (26) gefertigt ist, und dass die Kante (25) des Abschirmungsgehäuses (21) mit einer gleichen Anzahl von Vorsprüngen (25a) gefertigt ist, die zu den Nuten (26) komplementär sind.

4. PWB (printed wired board) (2; 22; 32) zum Anbringen von elektronischen Komponenten (8) und wenigstens eines Abschirmungsgehäuses (1; 11; 21; 31) zur Abschirmung der elektronischen Komponenten, und wobei das PWB (2; 22; 32) mit einer Nut (6; 26; 36) vorgesehen ist, die angepasst ist, um eine Kante (5; 15; 25; 35) eines Abschirmungsgehäuses aufzunehmen, **dadurch gekennzeichnet, dass** die Nut (36) zwischen zwei parallelen Streifen (39) vorgesehen ist, die von der Oberfläche des PWBs (32) hervorstehen.

5. PWB nach Anspruch 4, **dadurch gekennzeichnet, dass** die Streifen (37) Kupfer, das auf das PWB (39) plattiert ist, umfassen.

6. PWB nach Anspruch 4 oder 5, **dadurch gekennzeichnet, dass** die Nut aus einer Vielzahl von einzelnen Nuten (26) besteht, die angepasst sind, um Vorsprünge (25a), die an der Kante (25) des Abschirmungsgehäuses (21) vorgesehen sind, zu empfangen.

## Revendications

1. Procédé pour pourvoir une plaquette PWB (plaquette à câblage imprimé) (2 ; 22 ; 32) d'un capot de blindage (1 ; 11 ; 21 ; 31), lequel procédé comprend les étapes qui consistent :
- à pourvoir un capot électriquement conducteur (1 ; 11 ; 21 ; 31) de blindage d'un rebord (5 ; 15 ; 25; 35);
- à réaliser une gorge (6; 26 ; 36) sur une surface de la plaquette PWB,
- ladite gorge (6 ; 26 ; 36) étant plus large qu'une épaisseur du capot de blindage au niveau du rebord, et
- ladite gorge (6 ; 26 ; 36) ayant un contour correspondant à un contour du rebord du capot de blindage (1 ; 11 ; 21 ; 31) ;
- à appliquer une pâte à souder (7) à la plaquette PWB pour remplir sensiblement ladite gorge (6 ; 26 ; 36) de pâte à souder (7) ;
- à positionner le capot de blindage (1 ; 11 ; 21 ; 31) sur ladite pâte à souder (7) avec son rebord (5 ; 15 ; 25 ; 35) aligné avec ladite gorge sur ladite plaquette PWB ;
- à chauffer la plaquette PWB avec le capot de blindage et la pâte à souder pour souder le capot de blindage à la plaquette PWB ;
- à refroidir la plaquette PWB avec le capot de blindage,
**caractérisé en ce que** la gorge (36) est réalisée en appliquant deux bandes parallèles (39) qui font saillie de la surface de la plaquette PWB (32).

2. Procédé selon la revendication 1, **caractérisé en ce que** les bandes (39) sont appliquées par dépôt de cuivre sur la plaquette PWB (32).

3. Procédé selon la revendication 1 ou 2, **caractérisé en ce que** la gorge est réalisée sous la forme de plusieurs gorges discrètes (26), et **en ce que** le rebord (25) du capot de blindage (21) est réalisé avec un nombre égal de saillies (25a) qui sont complémentaires des gorges (26).

4. Plaquette PWB (plaquette à câblage imprimé) (2; 22 ; 32) destinée au montage de composants électroniques (8) et d'au moins un capot de blindage (1 ; 11 ; 21 ; 31) pour la protection par blindage des composants électroniques, et où la plaquette PWB (2 ; 22 ; 32) est pourvue d'une gorge (6 ; 26 ; 36) conçue pour recevoir un rebord (5 ; 15 ; 25 ; 35) du capot de blindage, **caractérisée en ce que** la gorge (36) est réalisée entre deux bandes parallèles (39) qui font saillie de la surface de la plaquette PWB (32).

5. Plaquette PWB selon la revendication 4, **caractérisée en ce que** les bandes (37) comprennent du cuivre déposé sur la plaquette PWB (39).

6. Plaquette PWB selon la revendication 4 ou 5, **caractérisée en ce que** la gorge est constituée de plusieurs gorges discrètes (26) conçues pour recevoir des saillies (25a) situées sur le rebord (25) du capot de blindage (21).
